# EUROPEAN PATENT APPLICATION

(11) **EP 4 279 632 A1**
(43) Date of publication of application: **22.11.2023**
(21) Application number: 23172451.9
(22) Date of filing: 09.05.2023
(51) Int. Cl.: C23C 14/04, C23C 16/44, G03F 9/00, H01L 21/308, H10K 71/16, C23F 1/02

(54) **APPARATUS FOR MANUFACTURING DISPLAY DEVICE, MASK ASSEMBLY, AND METHOD OF MANUFACTURING DISPLAY DEVICE**

(30) Priority: 17.05.2022 KR 20220060451; 20.07.2022 KR 20220089817
(71) Applicant: Samsung Display Co., Ltd., Yongin-si, Gyeonggi-do 17113 (KR)
(72) Inventor: KIM, Seil, 17113 Yongin-si (KR); CHOI, Minju, 17113 Yongin-si (KR)
(74) Representative: Walaski, Jan Filip

(57) **Abstract**

An apparatus for manufacturing a display device, a mask assembly, and a method of manufacturing a display device are provided. An apparatus for manufacturing a display device includes a chamber, a mask assembly arranged inside the chamber and including a mask sheet through which a deposition material passes, and a deposition source arranged inside the chamber and configured to supply the deposition material, and the mask sheet includes a body portion defining an exterior of the mask sheet, one or more opening portions in the body portion, and one or more groove portions in the body portion, and at least one of the one or more groove portions overlaps an inner surface of at least one of the one or more opening portions.

## Description

### CROSS-REFERENCE TO RELATED APPLICATIONS

This application claims priority to Korean Patent Application Nos. 10-2022-0060451, filed on May 17, 2022, and 10-2022-0089817, filed on July 20, 2022, in the Korean Intellectual Property Office.

### BACKGROUND

### 1. Field

Aspects of embodiments of the present disclosure relate to an apparatus for manufacturing a display device, a mask assembly, and a method of manufacturing a display device.

### 2. Description of the Related Art

Recently, electronic devices have been widely used. Electronic devices are used in various ways, such as mobile electronic devices and fixed electronic devices, and these electronic devices may include a display device capable of providing a user with visual information, such as images or videos, to support various functions.

A display device is a device that visually displays data and may be formed by depositing various layers, such as an organic layer and a metal layer. A deposition material may be deposited to form a plurality of layers of a display device. That is, the deposition material may be sprayed from a deposition source and used to be deposited on a substrate through a mask assembly. However, when the shape of a mask sheet is changed or an interference phenomenon occurs between the mask sheet and a shielding stick, the deposition material may not be deposited at a required position on the substrate, and, thus, deposition quality may be reduced.

The above-mentioned background art is technical information that the inventor may have possessed for deriving the disclosure or obtained in the process of deriving the disclosure, and is not necessarily known technology disclosed to the general public prior to the filing of the disclosure.

### SUMMARY

According to an aspect of one or more embodiments of the present disclosure, an apparatus for manufacturing a display device, which is able to reduce a blind spot formed in an opening portion of a mask sheet in a process in which a deposition material passes through the opening portion of the mask sheet, a mask assembly, and a method of manufacturing a display device are provided.

Additional aspects will be set forth, in part, in the description which follows and, in part, will be apparent from the description, or may be learned by practice of the presented embodiments of the disclosure.

According to one or more embodiments, an apparatus for manufacturing a display device includes a chamber, a mask assembly arranged inside the chamber and including a mask sheet configured to pass a deposition material therethrough, and a deposition source arranged inside the chamber and configured to supply the deposition material, wherein the mask sheet includes a body portion defining an exterior of the mask sheet, one or more opening portions in the body portion, and one or more groove portions in the body portion, wherein at least one of the one or more groove portions overlaps an inner surface of at least one of the one or more opening portions.

In one or more embodiments, the inner surface of the at least one opening portion may include an inclined surface inclined toward the deposition source.

In one or more embodiments, a planar shape of the at least one opening portion may include a circular shape.

In one or more embodiments, the one or more opening portions may comprise a plurality of opening portions, and the at least one groove portion may be in an area between four adjacent opening portions of the plurality of opening portions.

In one or more embodiments, inner surfaces of the four adjacent opening portions may overlap the at least one groove portion.

In one or more embodiments, the one or more opening portions may comprise a plurality of opening portions, and the at least one groove portion may be in an area between two adjacent opening portions of the plurality of opening portions.

In one or more embodiments, inner surfaces of the two adjacent opening portions may overlap the at least one groove portion.

In one or more embodiments, the one or more groove portions may comprise a plurality of groove portions, and the plurality of groove portions may be arranged to overlap an inner surface of one of the one or more opening portions.

In one or more embodiments, at least two of the plurality of groove portions arranged to overlap the inner surface of the one opening portion may overlap each other.

In one or more embodiments, a planar shape of the one or more groove portions may include a shape corresponding to a planar shape of the one or more opening portions.

According to one or more embodiments, a mask assembly includes a mask sheet configured to pass a deposition material therethrough, wherein the mask sheet includes a body portion defining an exterior of the mask sheet, one or more opening portions in the body portion, and one or more groove portions in the body portion, wherein at least one of the one or more groove portions may overlap an inner surface of at least one of the one or more opening portions.

In one or more embodiments, the one or more opening portions may include a first opening portion, a second opening portion, a third opening portion, and a fourth opening portion, which are arranged adjacent to each other, the one or more groove portions may include a first groove portion, and the first groove portion may be in an area between the first opening portion, the second opening portion, the third opening portion, and the fourth opening portion.

In one or more embodiments, an inner surface of each of the first opening portion, the second opening portion, the third opening portion, and the fourth opening portion may overlap the first groove portion.

In one or more embodiments, the one or more opening portions may include a first opening portion and a second opening portion, which are arranged adjacent to each other, the one or more groove portions may include a first groove portion, and the first groove portion may be in an area between the first opening portion and the second opening portion.

In one or more embodiments, an inner surface of each of the first opening portion and the second opening portion may overlap the first groove portion.

In one or more embodiments , the one or more opening portions may include a first opening portion, the one or more groove portions may include a first groove portion and a second groove portion, and the first groove portion and the second groove portion may overlap an inner surface of the first opening portion.

In one or more embodiments, the first groove portion and the second groove portion may overlap each other.

In one or more embodiments, an inner surface of the one or more opening portions may include an inclined surface.

In one or more embodiments, a planar shape of at least one of the one or more opening portions may include a circular shape.

In one or more embodiments, a planar shape of the one or more groove portions may include a shape corresponding to a planar shape of the one or more opening portions.

According to one or more embodiments, a method of manufacturing a display device includes arranging a display substrate and a mask assembly comprising a mask sheet inside a chamber, and depositing a deposition material supplied from a deposition source on the display substrate through the mask sheet, wherein the mask sheet includes a body portion defining an exterior of the mask sheet, one or more opening portions in the body portion, and one or more groove portions in the body portion, wherein at least one of the one or more groove portions overlaps an inner surface of at least one of the one or more opening portions.

In one or more embodiments, the inner surface of the at least one opening portion may include an inclined surface inclined toward the deposition source.

In one or more embodiments, a planar shape of at least one of the one or more opening portions may include a circular shape.

In one or more embodiments, the one or more opening portions may include a plurality of opening portions, and the at least one groove portion may be in an area between four adjacent opening portions of the plurality of opening portions.

In one or more embodiments, inner surfaces of the four adjacent opening portions may overlap the at least one groove portion.

In one or more embodiments, the one or more opening portions may include a plurality of opening portions, and the at least one groove portion may be in an area between two adjacent opening portions of the plurality of opening portions.

In one or more embodiments, inner surfaces of the two adjacent opening portions may overlap the at least one groove portion.

In one or more embodiments, the one or more groove portions may include a plurality of groove portions, and the plurality of groove portions may be arranged to overlap an inner surface of one of the one or more opening portion.

In one or more embodiments, at least two of the plurality of groove portions arranged to overlap the inner surface of the one opening portion may overlap each other.

In one or more embodiments, a planar shape of the one or more groove portions may include a shape corresponding to a planar shape of the one or more opening portions.

Other aspects, features, and advantages other than those described above will be apparent from the following drawings and detailed description of the disclosure.

### BRIEF DESCRIPTION OF THE DRAWINGS

The above and other aspects, features, and advantages of embodiments of the disclosure will be more apparent from the following description taken in conjunction with the accompanying drawings, in which:
FIG. 1 is a cross-sectional view of an apparatus for manufacturing a display device, according to an embodiment;
FIG. 2 is a schematic perspective view of a mask assembly according to an embodiment;
FIG. 3A is a schematic plan view of a mask sheet according to an embodiment;
FIG. 3B is a cross-sectional view of the mask sheet taken along the line I-I' of FIG. 3A, according to an embodiment;
FIG. 3C is a cross-sectional view of the mask sheet taken along the line I-I' of FIG. 3A, according to another embodiment;
FIG. 4A is a schematic plan view of a mask sheet according to an embodiment;
FIG. 4B is a cross-sectional view of the mask sheet taken along the line II-II' of FIG. 4A, according to an embodiment;
FIG. 4C is a cross-sectional view of the mask sheet taken along the line II-II' of FIG. 4A, according to another embodiment;
FIG. 5A is a schematic plan view of a mask sheet according to an embodiment;
FIG. 5B is a cross-sectional view of the mask sheet taken along the line III-III' of FIG. 5A, according to an embodiment;
FIG. 6A is a schematic plan view of a mask sheet according to an embodiment;
FIG. 6B is a cross-sectional view of the mask sheet taken along the line IV-IV of FIG. 6A, according to an embodiment;
FIG. 7 is a schematic perspective view of a display device according to an embodiment;
FIG. 8 is a cross-sectional view schematically illustrating a portion of the display device of FIG. 7, according to an embodiment; and
FIG. 9 is an equivalent circuit diagram of a pixel according to an embodiment.

### DETAILED DESCRIPTION

Reference will now be made in further detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, some particular embodiments will be illustrated in the drawings and described in further detail in the written description. Effects and features of the disclosure and methods of achieving the same will be apparent with reference to embodiments and drawings described below in further detail. The disclosure may, however, be embodied in many different forms and should not be construed as being limited to the embodiments set forth herein.

The disclosure will now be described more fully with reference to the accompanying drawings, in which some embodiments of the disclosure are shown. Like reference numerals in the drawings denote like elements, and, thus, their description may be omitted.

In the following embodiments, while such terms as "first," "second," etc., may be used to describe various elements, such elements are not to be limited to the above terms.

In the following embodiments, an expression used in the singular encompasses the expression of the plural, unless it has a clearly different meaning in the context.

In the following embodiments, it is to be understood that terms such as "including" and "having" are intended to indicate the existence of the features, or elements disclosed in the disclosure, and are not intended to preclude the possibility that one or more other features or elements may exist or may be added.

It is to be understood that when a layer, region, or component is referred to as being formed on another layer, region, or component, it may be directly or indirectly formed on the other layer, region, or component. That is, for example, one or more intervening layers, regions, or components may be present.

Sizes of components in the drawings may be exaggerated for convenience of explanation. In other words, since sizes and thicknesses of components in the drawings may be arbitrarily illustrated for convenience of explanation, the following embodiments are not limited thereto.

The x, y, and z axes, or similarly labeled axes, are not limited to three axes on the orthogonal coordinates system, and may be interpreted in a broad sense including the same. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

Unless otherwise defined, all terms (including technical and scientific terms) used herein have the same meaning as commonly understood by one of ordinary skill in the art to which the present disclosure belongs. It is to be further understood that terms, such as those defined in commonly used dictionaries, should be interpreted as having a meaning that is consistent with their meaning in the context of the relevant art and/or the present disclosure, and should not be interpreted in an idealized or overly formal sense, unless expressly so defined herein.

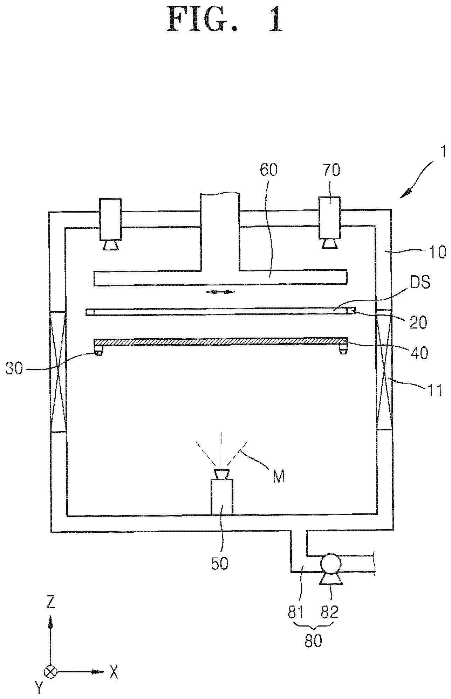

FIG. 1 is a cross-sectional view of an apparatus 1 for manufacturing a display device, according to an embodiment.

In an embodiment, the apparatus 1 for manufacturing a display device may include a chamber 10, a first support portion 20, a second support portion 30, a mask assembly 40, a deposition source 50, a magnetic force unit 60, a vision unit 70, and a pressure adjusting unit 80.

The chamber 10 has a space therein, and a display substrate DS and the mask assembly 40 may be accommodated in the space. A portion of the chamber 10 is formed to be opened, and a gate valve 11 may be installed in the open portion of the chamber 10. In this case, the open portion of the chamber 10 may be opened or closed according to the operation of the gate valve 11.

The display substrate DS may refer to a display substrate DS, on which at least one of an organic layer, an inorganic layer, and a metal layer is deposited on a substrate 100 to be described below, in a process of manufacturing a display device. Alternatively, the display substrate DS may be a substrate 100 on which any of an organic layer, an inorganic layer, and a metal layer has not yet been deposited.

The first support portion 20 may support the display substrate DS. In an embodiment, the first support portion 20 may have a plate shape fixed inside the chamber 10.
In an embodiment, the first support portion 20 may have a shuttle shape, on which the display substrate DS is seated and capable of performing a linear movement within the chamber 10. In an embodiment, the first support portion 20 may include an electrostatic chuck or an adhesive chuck fixed to the chamber 10 or arranged in the chamber 10 to be movable within the chamber 10.

The second support portion 30 may support the mask assembly 40. The second support portion 30 may be arranged in the chamber 10. The second support portion 30 may finely adjust the position of the mask assembly 40. In an embodiment, the second support portion 30 may have a separate driver or an alignment unit to move the mask assembly 40 in a different direction from that of the second support portion 30.

In an embodiment, the second support portion 30 may have a shuttle shape. In this case, the second support portion 30 may have the mask assembly 40 seated thereon and transfer the mask assembly 40. For example, the second support portion 30 may move to an outside of the chamber 10 and enter the chamber 10 from the outside of the chamber 10 after the mask assembly 40 is seated on the second support portion 30.

In an embodiment, the first support portion 20 may be integrally formed with the second support portion 30. In an embodiment, the first support portion 20 and the second support portion 30 may include a movable shuttle. In an embodiment, the first support portion 20 and the second support portion 30 include a structure for fixing the mask assembly 40 and the display substrate DS thereon when the display substrate DS is seated on the mask assembly 40, and are configured to linearly move the display substrate DS and the mask assembly 40 at the same time.

However, herein, for convenience of description, a case in which the first support portion 20 and the second support portion 30 are formed to be separate from each other and arranged at different positions in the chamber 10, and the first support portion 20 and the second support portion 30 are arranged inside the chamber 10, is mainly described in further detail.

The mask assembly 40 may be arranged inside the chamber 10 to face the display substrate DS. A deposition material M may be deposited on the display substrate DS by passing through the mask assembly 40.

The deposition source 50 may be arranged to face the mask assembly 40 and may supply the deposition material M such that the deposition material M is deposited on the display substrate DS by passing through a deposition area of the mask assembly 40. In an embodiment, the deposition source 50 may evaporate or sublimate the deposition material M by applying heat to the deposition material M. The deposition source 50 may be arranged to be fixed inside the chamber 10 or arranged inside the chamber 10 to be configured to linearly move in a direction.

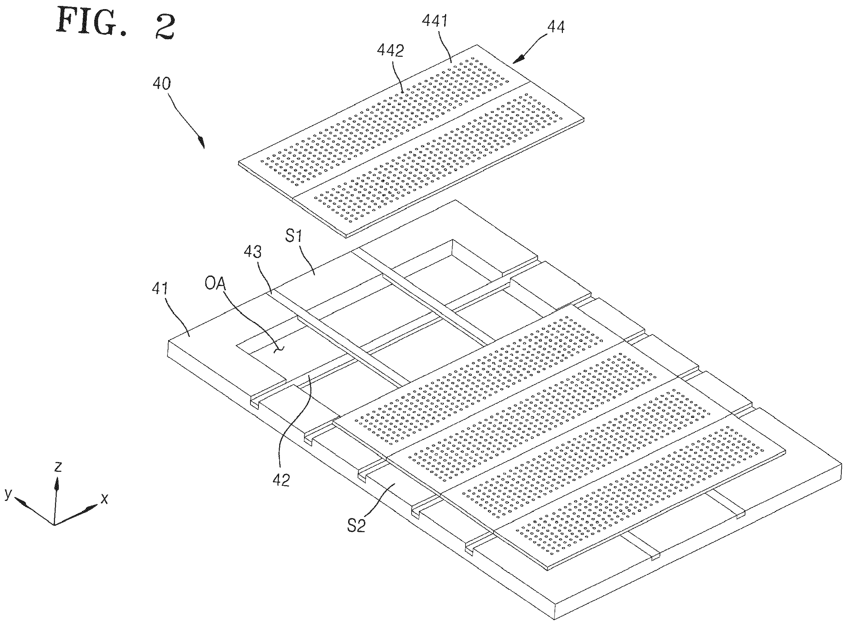

The magnetic force unit 60 may be arranged inside the chamber 10 to face the display substrate DS and/or the mask assembly 40. In an embodiment, the magnetic force unit 60 may press the mask assembly 40 toward a side of the display substrate DS by applying a magnetic force to the mask assembly 40. In particular, the magnetic force unit 60 may prevent or substantially prevent a mask sheet 44 (refer to FIG. 2) from sagging and also cause the mask sheet 44 to be adjacent to the display substrate DS. In addition, the magnetic force unit 60 may maintain a uniform gap between the mask sheet 44 and the display substrate DS.

The vision unit 70 may be arranged in the chamber 10 and may capture an image of positions of the display substrate DS and the mask assembly 40. In an embodiment, the vision unit 70 may include a camera that captures an image of the display substrate DS and the mask assembly 40. Based on an image captured by the vision unit 70, the positions of the display substrate DS and the mask assembly 40 may be determined, and the transformation of the mask assembly 40 may be confirmed. In addition, based on the image, the position of the display substrate DS may be finely adjusted by the first support portion 20, and the position of the mask assembly 40 may be finely adjusted by the second support portion 30. However, herein, a case in which the positions of the display substrate DS and the mask assembly 40 are aligned with each other by finely adjusting the position of the mask assembly 40 by the second support portion 30 is mainly described in further detail.

The pressure adjusting unit 80 may be connected to the chamber 10 to adjust a pressure inside the chamber 10. For example, the pressure adjusting unit 80 may adjust the pressure inside the chamber 10 to be equal to or similar to atmospheric pressure. In addition, the pressure adjusting unit 80 may adjust the pressure inside the chamber 10 to be equal to or similar to a vacuum state.

The pressure adjusting unit 80 may include a connection pipe 81 connected to the chamber 10 and a pump 82 installed on the connection pipe 81. Depending on the operation of the pump 82, external air may be introduced to the chamber 10 through the connection pipe 81, or a gas inside the chamber 10 may be guided to the outside through the connection pipe 81.

Referring to a method of manufacturing a display device (not shown) by using the apparatus 1 for manufacturing a display device as described above, the display substrate DS may be firstly prepared.

The pressure adjusting unit 80 may maintain the inside of the chamber 10 in a state that is same as or similar to atmospheric pressure, and the gate valve 11 may operate to open the open portion of the chamber 10.

Thereafter, the display substrate DS may be charged to the inside of the chamber 10 from the outside. The display substrate DS may be charged into the chamber 10 in various ways. For example, the display substrate DS may be charged into the chamber 10 from the outside of the chamber 10 by a robot arm arranged outside the chamber 10. In another embodiment, when the first support portion 20 is formed in a shuttle shape, after the first support portion 20 is carried out from the inside of the chamber 10 to the outside of the chamber 10, the display substrate DS may be seated on the first support portion 20, and the first support portion 20 may be charged into the chamber 10 from the outside of the chamber 10 by a separate robot arm or the like arranged outside the chamber 10.

The mask assembly 40 may be arranged inside the chamber 10 as described above. In another embodiment, the mask assembly 40 may be charged into the chamber 10 from the outside of the chamber 10 in a same or similar manner as the display substrate DS.

When the display substrate DS is charged into the chamber 10, the display substrate DS may be seated on the first support portion 20. The vision unit 70 may capture an image of the positions of the display substrate DS and the mask assembly 40. The positions of the display substrate DS and the mask assembly 40 may be determined based on the image captured by the vision unit 70. In an embodiment, the apparatus 1 for manufacturing a display device may have a separate controller (not shown) to determine the positions of the display substrate DS and the mask assembly 40.

When the positions of the display substrate DS and the mask assembly 40 have been determined, the second support portion 30 may finely adjust the position of the mask assembly 40.

Thereafter, the deposition source 50 may operate to supply the deposition material M to a side of the mask assembly 40, and the deposition material M passing through an opening portion of the mask sheet 44 may be deposited on the display substrate DS. In an embodiment, the deposition source 50 may move parallel to the display substrate DS and the mask assembly 40, or the display substrate DS and the mask assembly 40 may move parallel to the deposition source 50. That is, the deposition source 50 may move relative to the display substrate DS and the mask assembly 40. In an embodiment, the pump 82 may maintain the pressure inside the chamber 10 in a state that is same as or similar to a vacuum state by absorbing and discharging a gas inside the chamber 10 to the outside.

As described above, the deposition material M supplied from the deposition source 50 may be deposited on the display substrate DS by passing through the mask assembly 40, and, accordingly, a plurality of layers to be deposited on a display device to be described below, for example, at least one of an organic layer, an inorganic layer, and a metal layer, may be formed.

FIG. 2 is a schematic perspective view of the mask assembly 40 according to an embodiment.

Referring to FIG. 2, the mask assembly 40 may include a mask frame 41, a shielding stick (or strut or member) 42, a support stick (or strut or member) 43, and the mask sheet 44.

The mask frame 41 may be formed by connecting a plurality of sides, and may include an opening area OA defined by the plurality of sides. That is, the opening area OA may be formed by the plurality of surrounding sides, and the opening area OA may be formed through the center of the mask frame 41.

The mask frame 41 may be a rectangular frame in an embodiment. However, a shape of the mask frame 41 is not limited thereto and may be a polygonal shape of any of various shapes. Herein, for convenience of description, a case in which the mask frame 41 is a rectangular frame is mainly described.

When the mask frame 41 is a rectangular frame, the plurality of sides may include a first side S1 extending in a first direction (e.g., an X-axis direction), and a second side S2 extending in a second direction (e.g., a Y-axis direction) intersecting with the first direction. A pair of first sides S1 may be provided to face each other, and a pair of second sides S2 may be provided to face each other, wherein the pair or first sides S1 and the pair of second sides S2 may be connected to each other. In an embodiment, the first side S1 may be a short side, and the second side S2 may be a long side. However, the disclosure is not limited thereto, and the first side S1 may be a long side, and the second side S2 may be a short side, or the first side S1 may have a same length as that of the second side S2. Herein, for convenience of description, a case in which the first side S1 is a short side, and the second side S2 is a long side, is mainly described.

The shielding stick 42 may be arranged to extend in the first direction, for example, the X-axis direction as shown in FIG. 2, to cross the opening area OA. For example, grooves for accommodating both end portions of the shielding stick 42 may be arranged in the mask frame 41. However, this is an example, and a groove may not be arranged in the mask frame 41, and the shielding stick 42 may be disposed on the mask frame 41. The shielding stick 42 may be arranged to be positioned between a plurality of mask frames 41 to shield a space between two adjacent mask frames 41 such that the deposition material M may not pass through. A plurality of shielding sticks 42 may be provided and arranged to be spaced apart from each other in the second direction, for example, the Y-axis direction as shown in FIG. 2, and to be parallel to each other.

The support stick 43 may be arranged to extend in the second direction, for example, the Y-axis direction as shown in FIG. 2, to cross the opening area OA. The support stick 43 may intersect with the shielding stick 42 in the opening area OA and may be positioned on the shielding stick 42. For example, grooves for accommodating both end portions of the support stick 43 may be arranged in the mask frame 41. However, this is an example, and a groove may not be arranged in the mask frame 41, and the support stick 43 may be disposed on the mask frame 41. The support stick 43 may prevent or substantially prevent the mask sheet 44 from sagging by supporting the mask sheet 44 in the opening area OA.

In an embodiment, the mask sheet 44 may be installed in a tensioned state on the mask frame 41. At least a portion of the opening area OA at the center of the mask frame 41 may be covered by the mask sheet 44. In an embodiment, at least one mask sheet 44 may be provided, and when at least two mask sheets 44 are provided, the mask sheets 44 may be disposed on the mask frame 41 to be parallel to each other. For example, the mask sheets 44 may be arranged side-by-side in the second direction (e.g., the Y-axis direction). In an embodiment, each of the mask sheets 44 may have a shape extending to be long in the first direction (e.g., the X-axis direction). For example, both end portions of the mask sheet 44 may be fixed to the mask frame 41 by a welding method.

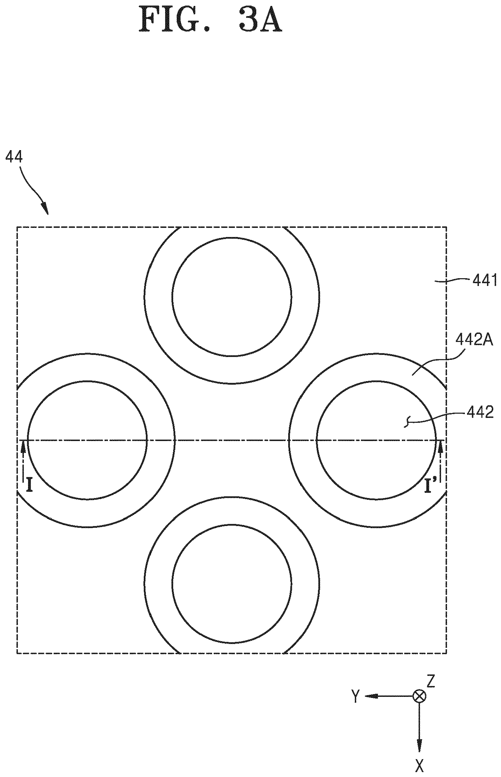

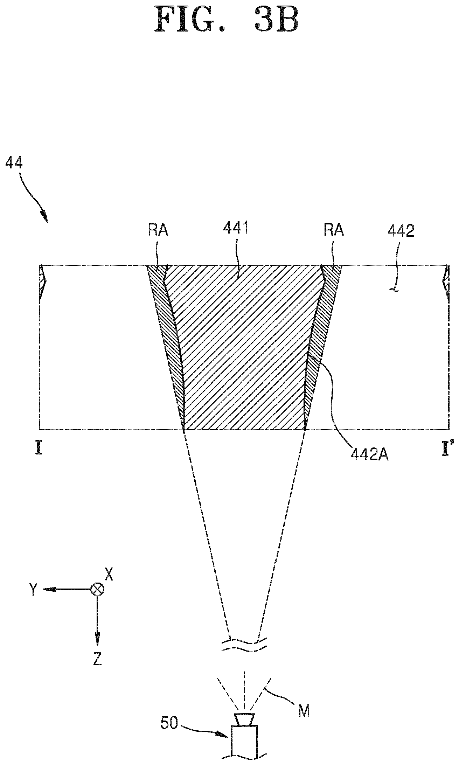

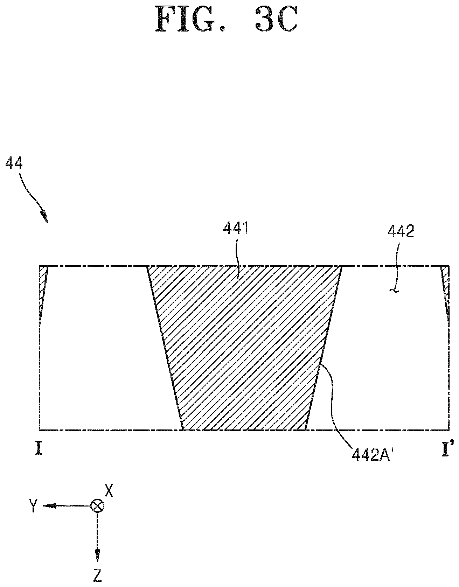

FIG. 3A is a schematic plan view of the mask sheet 44 according to an embodiment; FIG. 3B is a cross-sectional view of the mask sheet 44 taken along the line I-I' of FIG. 3A, according to an embodiment; and FIG. 3C is a cross-sectional view of the mask sheet 44 taken along the line I-I' of FIG. 3A, according to another embodiment. In particular, FIG. 3A is an enlarged view of the mask sheet 44 of FIG. 2 in a +Z-axis direction.

Referring to FIGS. 2 to 3C, the mask sheet 44 according to one or more embodiments may include a body portion 441 and an opening portion 442.

The body portion 441 may form, or define, an exterior of the mask sheet 44. The body portion 441 may be formed in a thin plate shape. For example, the body portion 441 may have a rectangular shape as shown in FIG. 2. However, the shape of the body portion 441 as shown in FIG. 2 is only an example, and the shape of the body portion 441 may vary depending on a purpose and use thereof.

At least one opening portion 442 may be provided and arranged in the body portion 441 to allow the deposition material M to pass therethrough. The opening portion 442 may be formed through a surface (e.g., a surface facing a +Z axis) of the body portion 441 in a thickness direction (e.g., a -Z-axis direction) of the mask sheet 44. In an embodiment, a planar shape of at least one of the opening portions 442 may be circular. For example, a planar shape of each of a plurality of the opening portions 442 may be a circular shape. In an embodiment, because the planar shape of the opening portion 442 is formed in a circular shape, the deposition material M to be deposited on a display substrate may also have a circular shape.

As shown in FIGS. 3B and 3C, an inner surface 442A of the opening portion 442 may include an inclined surface based on a cross-section parallel to a thickness direction (e.g., the Z-axis direction) of the mask sheet 44. In an embodiment, the inclined surface may be inclined toward the deposition source 50. In such a configuration, when the planar shape of the opening portion 442 is circular in a plan view as shown in FIG. 3A, the planar shape of the inclined surface may be annular.

Referring to FIGS. 3B and 3C, a cross-sectional shape of the opening portion 442 may vary. For example, when the opening portion 442 is formed by an etchant, the inner surface 442A may include a curved surface, as shown in FIG. 3B. In an embodiment, for example, when the opening portion 442 is formed by a laser, an inner surface 442A' may include a flat surface, as shown in FIG. 3C. The shapes of the opening portions 442 illustrated in FIGS. 3B and 3C are only examples, and the cross-sectional shape of the opening portion 442 is not limited thereto. Herein, for convenience of description, description is made based on the opening portion 442 being formed by an etchant as shown in FIG. 3B.

Referring to FIG. 3B, a blind spot RA that the deposition material M may not reach due to being covered by the body portion 441 may be formed in the opening portion 442. That is, while the deposition material M is supplied from the deposition source 50, the blind spot RA through which the deposition material M may not pass while the deposition material M is deposited on the body portion 441 may be formed in the opening portion 442. Due to the blind spot RA, the shape of the deposition material M to be deposited on a display substrate DS may be smaller than the planar shape of the opening portion 442.

In a plan view, a plurality of opening portions 442 may be alternately arranged with each other, as shown in FIG. 3A. However, the arrangement of the opening portions 442 illustrated in FIG. 3A is only an example, and the arrangement of the opening portions 442 is not limited thereto. Herein, for convenience of description, description is made based on the plurality of opening portions 442 being alternately arranged with each other as shown in FIG. 3A.

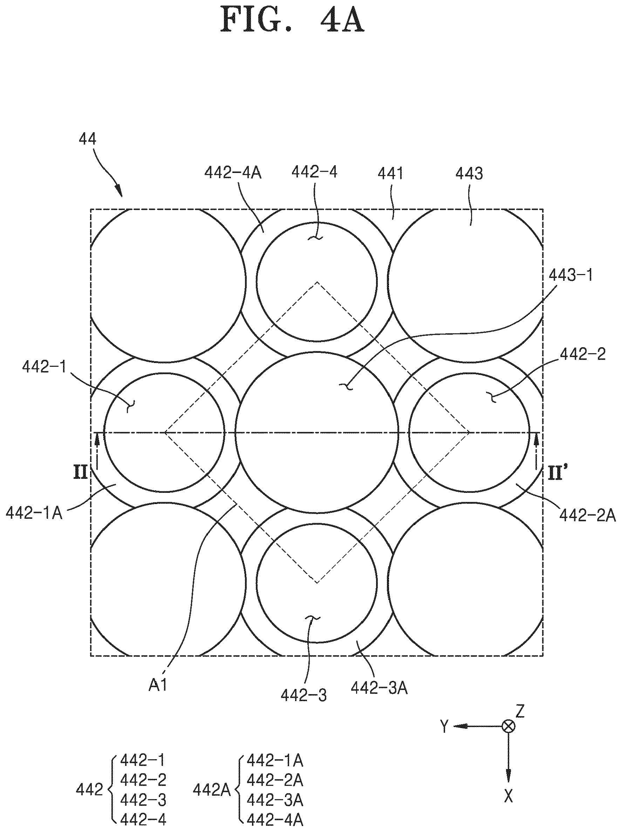

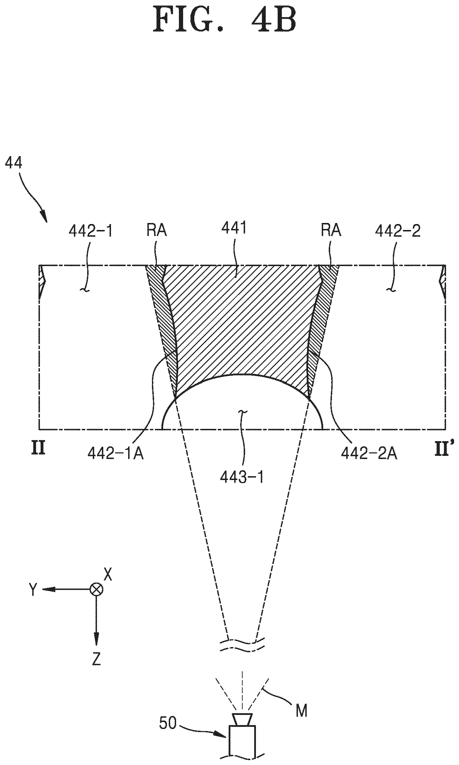

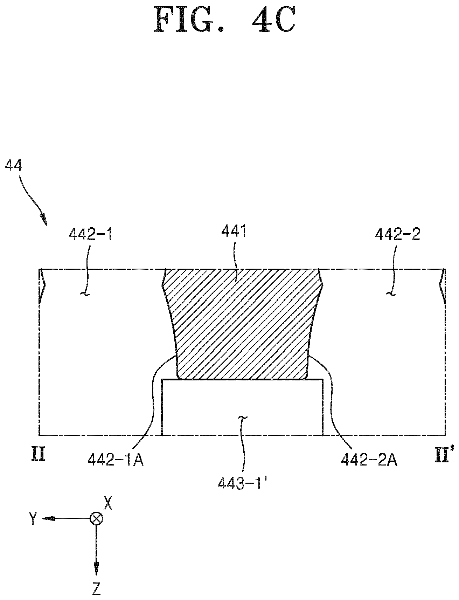

FIG. 4A is a schematic plan view of the mask sheet 44 according to an embodiment; FIG. 4B is a cross-sectional view of the mask sheet 44 taken along the line II-II' of FIG. 4A, according to an embodiment; and FIG. 4C is a cross-sectional view of the mask sheet 44 taken along the line II-II' of FIG. 4A, according to another embodiment.

Referring to FIGS. 4A to 4C, the mask sheet 44 according to an embodiment may include the body portion 441, the opening portion 442, and a groove portion 443. The opening portion 442 may include a first opening portion 442-1, a second opening portion 442-2, a third opening portion 442-3, and a fourth opening portion 442-4.

Because the body portion 441 and the opening portion 442 described with reference to FIGS. 4A to 4C are substantially the same as the body portion 441 and the opening portion 442 described with reference to FIGS. 2 to 3C, redundant descriptions thereof are omitted for convenience of description.

At least one groove portion 443 may be provided to be arranged in the body portion 441. The groove portion 443 may be formed to be recessed in a surface (e.g., a surface facing the +Z axis) of the body portion 441 in the thickness direction of the mask sheet 44. At least one of the groove portions 443 may overlap the inner surface 442A of at least one of the opening portions 442.

A planar shape of the groove portion 443 may be a shape corresponding to that of the opening portion 442. That is, when the planar shape of the opening portion 442 is circular, the planar shape of the groove portion 443 may be circular. However, this is only an example, and the planar shape of the groove portion 443 is not limited thereto. For example, the planar shape of the groove portion 443 may be a polygonal shape or an annular shape.

Referring to FIG. 4A, the plurality of opening portions 442 may be provided, and at least one of the groove portions 443 may be arranged in an area A1 between four adjacent opening portions 442. Here, the area A1 between the four adjacent opening portions 442 may be an area inside a rectangle formed when virtual lines are drawn between the centers of the four adjacent opening portions 442.

For example, the groove portions 443 may include a first groove portion 443-1, and the first groove portion 443-1 may be arranged in the area A1 between the first opening portion 442-1, the second opening portion 442-2, the third opening portion 442-3, and the fourth opening portion 442-4, which are arranged adjacent to each other. The inner surfaces 442A of the four adjacent opening portions 442 may overlap at least one of the groove portions 443. For example, each of an inner surface 442-1A of the first opening portion 442-1, an inner surface 442-2A of the second opening portion 442-2, an inner surface 442-3A of the third opening portion 442-3, and an inner surface 442-4A of the fourth opening portion 442-4 may overlap the first groove portion 443-1.

As at least one of a plurality of groove portions 443 overlaps the inner surface 442A of at least one of the opening portions 442, and a portion of the body portion 441, the portion being in contact with the inner surface 442A of the opening portion 442, may be removed by the groove portion 443. For example, referring to FIGS. 4B and 4C, as the first groove portion 443-1 is arranged between the first opening portion 442-1 and the second opening portion 442-2, a portion of the body portion 441, the portion being in contact with the inner surface 442-1A of the first opening portion 442-1 and the inner surface 442-2A of the second opening portion 442-2, may be removed. In such a configuration, while the deposition source 50 provides the deposition material M, the blind spot RA of the opening portion 442, through which the deposition material M may not pass, may be reduced.

Referring to FIGS. 4B and 4C, a cross-sectional shape of the groove portion 443 may vary. For example, when the groove portion 443 is formed by an etchant, an inner surface of the first groove portion 443-1 may include a concave shape as shown in FIG. 4B. However, this is only an example, and the cross-sectional shape of the groove portion 443 is not limited thereto. For example, as shown in FIG. 4C, the cross-sectional shape of a first groove portion 443-1' may also include a linear shape. Herein, for convenience of description, description is based on the groove portion 443 being formed by an etchant as shown in FIG. 4B.

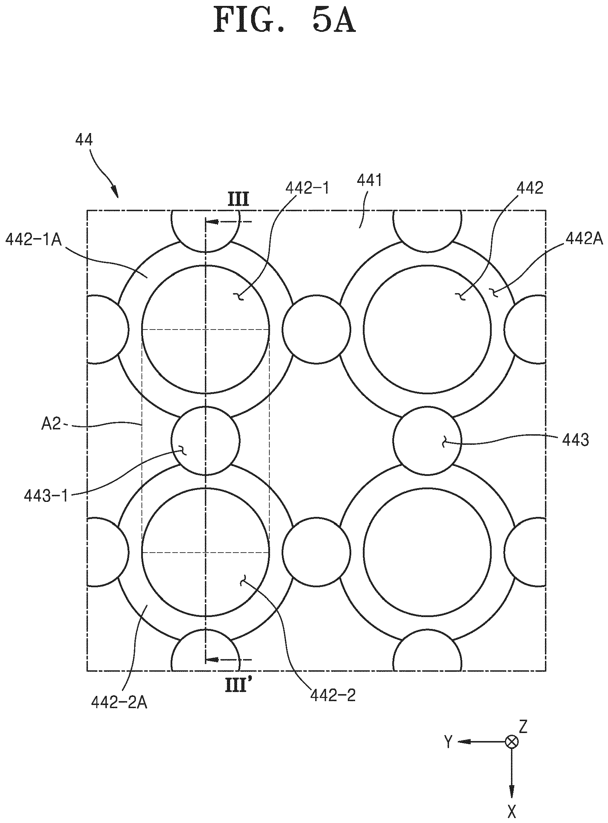

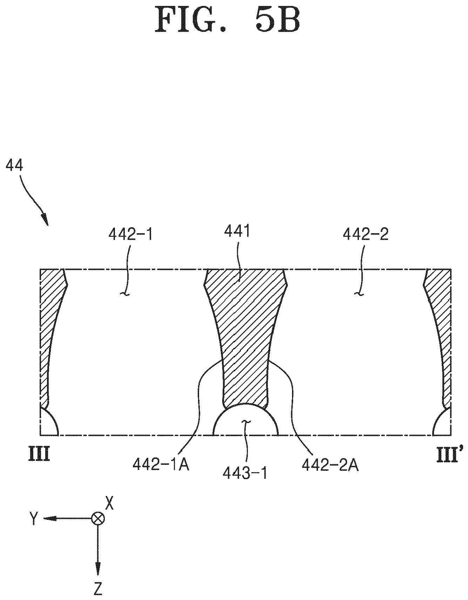

FIG. 5A is a schematic plan view of the mask sheet 44 according to an embodiment; and FIG. 5B is a cross-sectional view of the mask sheet 44 taken along the line III-III' of FIG. 5A, according to an embodiment.

Referring to FIGS. 5A and 5B, the mask sheet 44 according to an embodiment may include the body portion 441, the opening portion 442, and the groove portion 443. The opening portion 442 may include the first opening portion 442-1 and the second opening portion 442-2, and the groove portion 443 may include the first groove portion 443-1.

Because the body portion 441, the opening portion 442, and the groove portion 443 described with reference to FIGS. 5A and 5B are substantially the same as the body portion 441, the opening portion 442, and the groove portion 443 described with reference to FIGS. 4A and 4B, redundant descriptions thereof are omitted for convenience of description.

The plurality of opening portions 442 shown in FIGS. 5A and 5B may be arranged side-by-side, unlike the plurality of opening portions 442 described with reference to FIGS. 4A and 4B. In other words, opening portions 442 adjacent to an opening portion 442 may be arranged in vertical and horizontal directions (e.g., X-axis and Y-axis directions).

Referring to FIG. 5A, at least one of the groove portions 443 may be arranged in an area A2 between two adjacent opening portions 442. Here, the area A2 between the two adjacent opening portions 442 may be an area inside a rectangle to be formed when a virtual line passing through the center of each of the two adjacent opening portions 442 and virtual lines connecting the inner surfaces 442A of the two adjacent opening portions 442 are drawn.

For example, the first groove portion 443-1 may be arranged in the area A2 between the first opening portion 442-1 and the second opening portion 442-2, which are arranged adjacent to each other. The inner surfaces 442A of the two adjacent opening portions 442 may overlap at least one of the groove portions 443. For example, the inner surface 442-1A of the first opening portion 442-1 and the inner surface 442-2A of the second opening portion 442-2 may overlap the first groove portion 443-1.

In such a configuration, referring to FIG. 5B, a portion of the body portion 441, the portion being in contact with the inner surface 442A of each of the two adjacent opening portions 442, may be removed. For example, as the first groove portion 443-1 is arranged between the first opening portion 442-1 and the second opening portion 442-2, a portion of the body portion 441, the portion being in contact with the inner surface 442-1A of the first opening portion 442-1 and the inner surface 442-2A of the second opening portion 442-2, may be removed. In such a structure, in a process in which a deposition source (e.g., the deposition source 50 of FIG. 4B) provides a deposition material (e.g., the deposition material M of FIG. 4B), a blind spot (e.g., the blind spot RA of FIG. 4B) of the opening portion 442, through which the deposition material M may not pass, may be reduced.

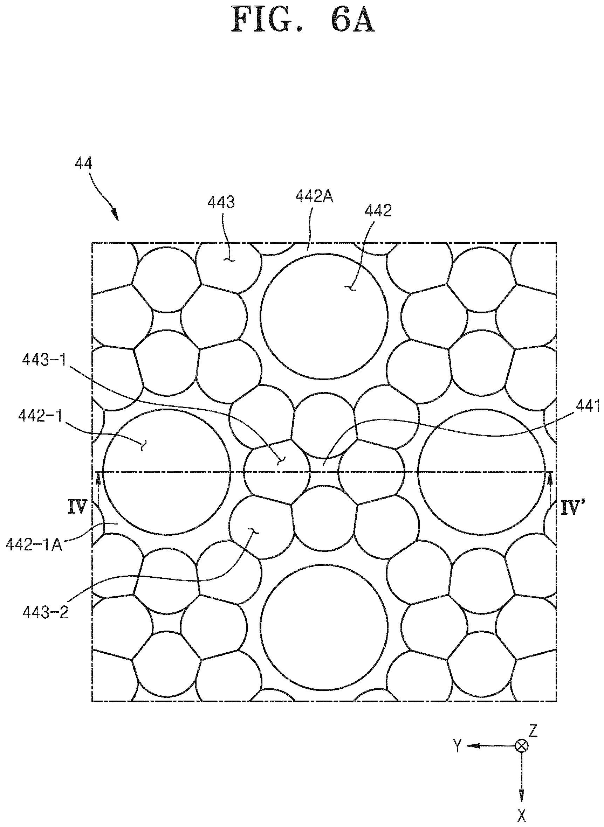

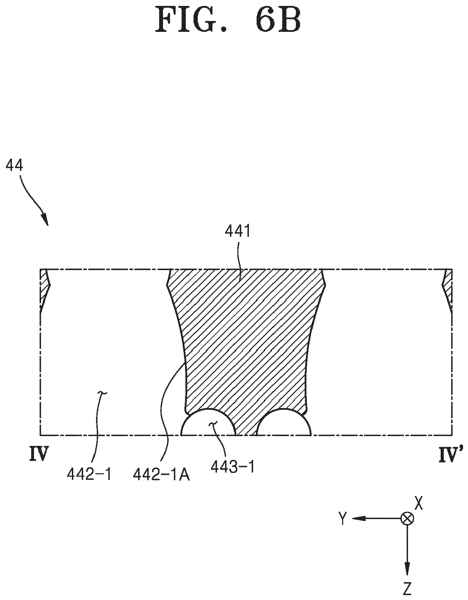

FIG. 6A is a schematic plan view of the mask sheet 44 according to an embodiment; and FIG. 6B is a cross-sectional view of the mask sheet 44 taken along the line IV-IV' of FIG. 6A, according to an embodiment.

Referring to FIGS. 6A and 6B, the mask sheet 44 according to an embodiment may include the body portion 441, the opening portion 442, and the groove portion 443. The opening portion 442 may include the first opening portion 442-1, and the groove portion 443 may include the first groove portion 443-1 and a second groove portion 443-2.

Because the body portion 441, the opening portion 442, and the groove portion 443 described with reference to FIGS. 6A and 6B are substantially the same as the body portion 441, the opening portion 442, and the groove portion 443 described with respect to FIGS. 4A and 4B, redundant descriptions thereof are omitted for convenience of description.

Referring to FIGS. 6A and 6B, the plurality of groove portions 443 may be arranged to overlap the inner surface 442A of one opening portion 442. For example, the first groove portion 443-1 and the second groove portion 443-2 may overlap the inner surface 442-1A of the first opening portion 442-1. At least two of the plurality of groove portions 443 arranged to overlap the inner surface 442A of one opening portion 442 may overlap each other. For example, the first groove portion 443-1 and the second groove portion 443-2 may overlap each other.

In such a configuration, a portion of the body portion 441, the portion being in contact with the inner surface 442A of the opening portion 442 overlapping the plurality of groove portions 443, may be removed. For example, as the first groove portion 443-1 and the second groove portion 443-2 are arranged to overlap the inner surface 442-1A of the first opening portion 442-1, a portion of the body portion 441, the portion being in contact with the inner surface 442-1A of the first opening portion 442-1, may be removed. In such a structure, in a process in which a deposition source (e.g., the deposition source 50 of FIG. 4B) provides a deposition material (e.g., the deposition material M of FIG. 4B), a blind spot (e.g., the blind spot RA of FIG. 4B) of the opening portion 442, through which the deposition material M may not pass, may be reduced.

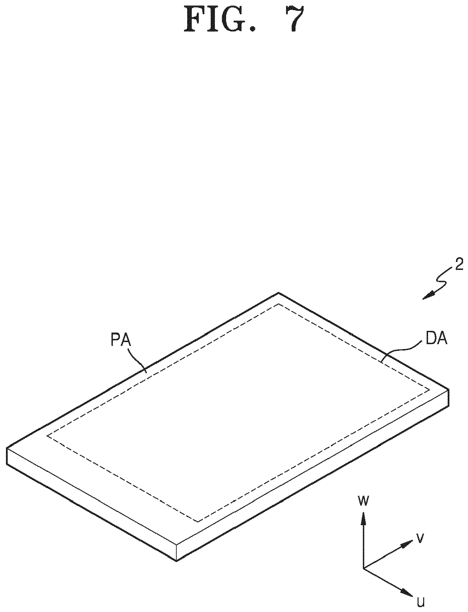

FIG. 7 is a schematic perspective view of a display device 2 according to an embodiment.

Referring to FIG. 7, the display device 2 according to embodiments may be implemented as an electronic device, such as a smartphone, a mobile phone, a smart watch, a navigation device, a game machine, a television (TV), an automotive head unit, a notebook computer, a laptop computer, a tablet computer, a personal media player (PMP), a personal digital assistant (PDA), or the like. In addition, the electronic device may be a flexible device.

The display device 2 may include a display area DA, in which an image is displayed, and a peripheral area PA around the display area DA. The display device 2 may provide a certain image by using light emitted from a plurality of pixels arranged in the display area DA.

The display device 2 may have any of various shapes, for example, a rectangular plate shape having two pairs of sides respectively parallel to each other. When the display device 2 has a rectangular plate shape, one pair of sides among two pairs of sides thereof may be longer than the other pair of sides. In an embodiment, for convenience of description, a case in which the display device 2 has a rectangular shape having a pair of long sides and a pair of short sides is shown, wherein an extension direction of the pair of short sides is indicated as a first direction (u-axis direction), an extension direction of the pair of long sides is indicated as a second direction (v-axis direction), and a direction perpendicular to the pair of long sides and the pair of short sides is indicated as a third direction (w-axis direction). In another embodiment, the display device 2 may have a non-rectangular shape. The non-rectangular shape may include, for example, a circular shape, an elliptical shape, a partially circular polygonal shape, or a polygonal shape other than a rectangular shape.

In a plan view of the display area DA, the display area DA may have a rectangular shape, as shown in FIG. 7. As another embodiment, the display area DA may have a polygonal shape, such as a triangular shape, a pentagonal shape, a hexagonal shape, or the like, or a circular shape, an elliptical shape, an atypical shape, or the like.

The peripheral area PA is an area around the display area DA, and may be a type of non-display area in which pixels are not arranged. In an embodiment, the display area DA may be entirely surrounded by the peripheral area PA. Various lines configured to provide electrical signals to the display area DA, as well as pads to which a printed circuit board or a driver integrated circuit (IC) chip is attached may be in the peripheral area PA.

Herein, according to an embodiment, an organic light-emitting display device is described as an example of the display device 2. However, the display device 2 of the present disclosure is not limited thereto. As another embodiment, the display device 2 of the present disclosure may be a display device, such as an inorganic light-emitting display device or an inorganic electroluminescence (EL) display device, or a quantum dot light-emitting display device.

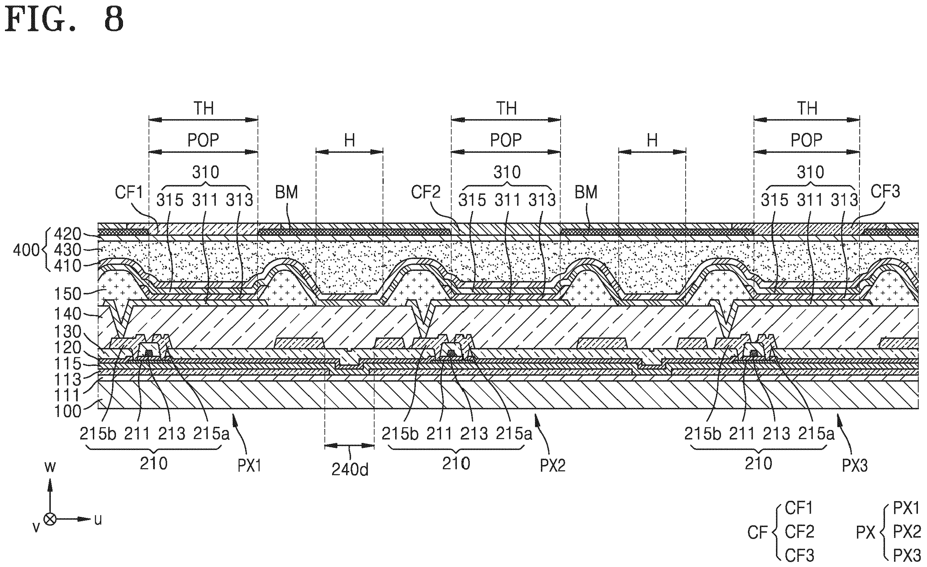

FIG. 8 is a cross-sectional view schematically illustrating a portion of the display device of FIG. 7, according to an embodiment, and particularly, is a cross-sectional view schematically illustrating a portion of the display area DA of FIG. 7. As shown in FIG. 8, the display device according to the present embodiment has a plurality of pixels in the display area DA. FIG. 8 illustrates that the plurality of pixels PX includes a first pixel PX1, a second pixel PX2, and a third pixel PX3. However, this is an example, and the display device may have more pixels in the display area DA. In addition, FIG. 8 illustrates that the first pixel PX1 to the third pixel PX3 are adjacent to each other, but the disclosure is not limited thereto. In other words, other components, such as other lines or the like, may be arranged between the first pixel PX1 to the third pixel PX3. Accordingly, the first pixel PX1 and the second pixel PX2 may not be pixels adjacent to each other. In addition, cross-sections of the first pixel PX1 to the third pixel PX3 in FIG. 8 may not be cross-sections in the same direction.

The display device according to an embodiment includes the substrate 100. The substrate 100 may include glass, metal, or polymer resin. When the substrate 100 is flexible or bendable, the substrate 100 may include, for example, polymer resin, such as polyethersulfone, polyacrylate, polyetherimide, polyethylene naphthalate, polyethylene terephthalate, polyphenylene sulfide, polyarylate, polyimide, polycarbonate, or cellulose acetate propionate. In an embodiment, the substrate 100 may have a multi-layered structure including two layers each including the polymer resin and a barrier layer including an inorganic material (for example, silicon oxide, silicon nitride, silicon oxynitride, or the like) arranged between the two layers, and various modifications may be made.

In the display area DA as shown in FIG. 8, the plurality of pixels PX are disposed on the substrate 100. Because each of the plurality of pixels PX includes a display element 310 having a first pixel electrode, it may be understood that a plurality of pixel electrodes 311 are disposed on the substrate 100 in the display area DA. In the display area DA, in addition to the display elements 310, thin-film transistors 210 electrically connected to the display elements 310 may also be on the substrate 100. For reference, FIG. 8 illustrates that organic light-emitting diodes each having the pixel electrode 311, an intermediate layer 313, and an opposite electrode 315 may be positioned on the substrate 100 as the display elements 310. The organic light-emitting diodes being electrically connected to the thin-film transistors 210 may be understood as that each of the pixel electrodes 311 is electrically connected to its corresponding thin-film transistor 210.

The thin-film transistor 210 may include a semiconductor layer 211 including amorphous silicon, polycrystalline silicon, an organic semiconductor material, or an oxide semiconductor material, a gate electrode 213, a source electrode 215a, and a drain electrode 215b. The gate electrode 213 may include any of various conductive materials and may have any of various layered structures, and, for example, may include a Mo layer and an Al layer. In an embodiment, the gate electrode 213 may include a TiNx layer, an Al layer, and/or a Ti layer. Each of the source electrode 215a and the drain electrode 215b may also include any of various conductive materials and may have any of various layered structures, and, for example, may include a Ti layer, an Al layer, and/or a Cu layer.

To provide insulation between the semiconductor layer 211 and the gate electrode 213, a gate insulating layer 120 including an inorganic material, such as silicon oxide, silicon nitride, and/or silicon oxynitride, or the like, may be between the semiconductor layer 211 and the gate electrode 213. In addition, an interlayer insulating layer 130 including an inorganic material, such as silicon oxide, silicon nitride, and/or silicon oxynitride, or the like, may be disposed on the gate electrode 213, and the source electrode 215a and the drain electrode 215b may be disposed on the interlayer insulating layer 130. In an embodiment, an insulating layer including the inorganic material may be formed through chemical vapor deposition (CVD) or atomic layer deposition (ALD). The above description is similar to the embodiments and modification examples thereof to be described below.

For example, FIG. 8 illustrates that the thin-film transistor 210 includes the source electrode 215a and the drain electrode 215b, but the disclosure is not limited thereto. For example, the source electrode 215a and/or the drain electrode 215b may be a portion of lines. In an embodiment, the thin-film transistor 210 may not have the source electrode 215a and/or the drain electrode 215b, and a source area of the semiconductor layer 211 may function as a source electrode, or a drain area of the semiconductor layer 211 may function as a drain electrode. For example, the source area of the semiconductor layer 211 of the thin-film transistor 210 may be integral with a drain area of another thin-film transistor. In this case, it may be understood as that a drain electrode of the other thin-film transistor is electrically connected to the source area of the thin-film transistor 210.

In addition to the source electrode 215a and the drain electrode 215b, lines may be on the interlayer insulating layer 130. A gap 240d may be maintained between the lines.

A first buffer layer 111 including an inorganic material, such as silicon oxide, silicon nitride, and/or silicon oxynitride, or the like, may be between the thin-film transistor 210 in such a structure and the substrate 100. The first buffer layer 111 may increase smoothness of an upper surface of the substrate 100, or may prevent or substantially prevent penetration of impurities from the substrate 100 or the like into the semiconductor layer 211 of the thin-film transistor 210.

In addition, a second buffer layer 115 may be between the thin-film transistor 210 and the first buffer layer 111, and a lower metal layer 113 may be between the first buffer layer 111 and the second buffer layer 115. The second buffer layer 115 may include an inorganic material, such as silicon oxide, silicon nitride, and/or silicon oxynitride, or the like. The lower metal layer 113 may include Ti, Al, Cu, Mo, or the like. The lower metal layer 113 may minimize or reduce the influence of electromagnetic waves or light from the outside on the thin-film transistor 210 or the like. In an embodiment, the lower metal layer 113 has holes in the display area DA.

A planarization layer 140 may be disposed on the thin-film transistor 210. For example, as shown in FIG. 8, when an organic light-emitting diode is disposed above the thin-film transistor 210, the planarization layer 140 may have a substantially flat upper surface, such that the organic light-emitting diode may be positioned on the substantially flat upper surface of the planarization layer 140. The planarization layer 140 may include, for example, an organic material, such as acryl, benzocyclobutene (BCB), hexamethyldisiloxane (HMDSO), or the like. Although FIG. 8 illustrates the planarization layer 140 as a single layer, various modifications are possible, for example, the planarization layer 140 may be a multi-layer.

In the display area DA, the display element 310 may be on the planarization layer 140 of the substrate 100. The organic light-emitting diode as shown in FIG. 8 may be used as the display element 310. As described above, the organic light-emitting diode included in each of the display elements 310 may include the pixel electrode 311, the opposite electrode 315, and the intermediate layer 313 between the pixel electrode 311 and the opposite electrode 315 and including an emission layer.

As shown in FIG. 8, the pixel electrode 311 is electrically connected to the thin-film transistor 210 by being in contact with any one of the source electrode 215a and the drain electrode 215b through a contact hole formed in the planarization layer 140 or the like. In an embodiment, each of the pixel electrodes 311 includes a transparent conductive layer including any of a transparent conductive oxide, such as ITO, In₂O₃, IZO, or the like, and a reflective layer including a metal, such as Al, Ag, or the like. For example, each of the pixel electrodes 311 may have a triple-layered structure of ITO/Ag/ITO.

The intermediate layer 313 including the emission layer may be on its corresponding pixel electrode 311. The intermediate layer 313 may include a low-molecular-weight material or a polymer material. When the intermediate layer 313 includes a low-molecular-weight material, the intermediate layer 313 may have a structure in which a hole injection layer (HIL), a hole transport layer (HTL), an emission layer (EML), an electron transport layer (ETL), an electron injection layer (EIL), and/or the like are stacked in a single or complex structure, and may be formed by a vacuum deposition method. When the intermediate layer 313 includes a polymer material, the intermediate layer 313 may have a structure including an HTL and an EML. The HTL may include poly(3,4-ethylenedioxythiophene) (PEDOT), and the EML may include a polymer material, such as a poly(p-phenylene vinylene) (PPV)-based polymer material, a polyfluorene-based polymer material, or the like. The intermediate layer 313 may be formed by a screen printing method, an inkjet printing method, a vapor deposition method, a laser induced thermal imaging (LITI) method, or the like. However, the intermediate layer 313 is not limited thereto, and may also have any of various structures.

Layers other than the emission layer of the intermediate layer 313 may be integrally formed over the plurality of pixel electrodes 311. The emission layer of the intermediate layer 313 may be on a corresponding pixel electrode 311. An emission layer in the first pixel PX1 may emit, for example, red light, an emission layer in the second pixel PX2 may emit, for example, green light, and an emission layer in the third pixel PX3 may emit, for example, blue light.

In an embodiment, the opposite electrode 315 on the intermediate layer 313 may be integrally formed over the plurality of pixel electrodes 311. The opposite electrode 315 may include a transparent conductive layer including ITO, In₂O₃, or IZO, and may also include a semi-transparent film including Al, Ag, or the like. For example, the opposite electrode 315 may include a semi-transparent film including MgAg.

A pixel defining layer 150 may be disposed on the planarization layer 140. The pixel defining layer 150 defines a pixel by having a pixel opening POP corresponding to each of the plurality of pixels PX, that is, the pixel opening POP through which at least a central portion of each of the pixel electrodes 311 is exposed. As shown in FIG. 8, the pixel defining layer 150 prevents or substantially prevents arcs or the like from being generated at edges of the pixel electrodes 311 by increasing a distance between an edge of each of the pixel electrodes 311 and the opposite electrode 315. In addition, the pixel defining layer 150 has holes H between the pixel electrodes 311 in the display area DA, the holes H corresponding to the pixel electrodes 311.

The pixel defining layer 150 may include, for example, an organic material, such as polyimide, HMDSO, or the like. In addition, the pixel defining layer 150 may include a light-blocking insulating material. Accordingly, in an embodiment, the pixel defining layer 150 is a light-blocking insulating layer which is colored and opaque, and for example, may appear black. For example, the pixel defining layer 150 may include a polyimide (PI)-based binder, and a pigment in which red, green, and blue colors are mixed with each other. In an embodiment, the pixel defining layer 150 may include a binder, and a mixture of a lactam black pigment and a blue pigment. In an embodiment, the pixel defining layer 150 may include carbon black. The pixel defining layer 150 may improve the contrast of the display device.

Because the organic light-emitting diode may be easily damaged by moisture or oxygen from the outside, as shown in FIG. 8, an encapsulation layer 400 including a first inorganic encapsulation layer 410, a second inorganic encapsulation layer 420, and an organic encapsulation layer 430 therebetween may protect the organic light-emitting diodes by covering the organic light-emitting diodes.

Each of the first inorganic encapsulation layer 410 and the second inorganic encapsulation layer 420 may include at least one inorganic insulating material. In an embodiment, the at least one inorganic insulating material may be aluminum oxide, titanium oxide, tantalum oxide, hafnium oxide, zinc oxide, silicon oxide, silicon nitride, and/or silicon oxynitride.

The organic encapsulation layer 430 may include a polymer-based material. The polymer-based material may include an acrylic resin, an epoxy resin, polyimide and/or polyethylene, or the like. For example, the organic encapsulation layer 430 may include an acrylic resin, polymethyl methacrylate, and/or polyacrylic acid, or the like. The organic encapsulation layer 430 may be formed by curing a monomer or coating a polymer.

In the display area DA, an anti-reflection layer may be above the encapsulation layer 400. The anti-reflection layer may reduce unnecessary or undesired reflection of light. The anti-reflection layer may include color filters CF and a black matrix BM. The black matrix BM of the anti-reflection layer has through holes TH in the display area DA.

The color filters CF may fill the through holes of the black matrix BM. Accordingly, the black matrix BM may be in contact with the color filters CF. In an embodiment, the color filters CF may include a first color filter CF1, a second color filter CF2, and a third color filter CF3. The first color filter CF1 may allow light in a particular wavelength band to which the wavelength of light from a display element disposed therebelow belongs to pass through.

FIG. 8 illustrates that the first color filter CF1, which is a red color filter that allows red light to pass through the first pixel PX1 (which may also be referred to as a red pixel), is positioned to fill the through hole TH of the black matrix BM corresponding to the pixel opening POP of the pixel defining layer 150, the second color filter CF2, which is a green color filter that allows green light to pass through the second pixel PX2 (which may also be referred to as a green pixel), is positioned to fill the through hole TH of the black matrix BM corresponding to the pixel opening POP of the pixel defining layer 150, and the third color filter CF3, which is a blue color filter that allows blue light to pass through the third pixel PX3 (which may also be referred to as a blue pixel), is positioned fill the through hole TH of the black matrix BM corresponding to the pixel opening POP of the pixel defining layer 150.

The color filters CF may reduce external light reflection in the display device. For example, when external light reaches the first color filter CF1, only light having a wavelength in a wavelength band corresponding to red light passes through the first color filter CF1, and light having other wavelengths is absorbed by the first color filter CF1. Accordingly, only light having a wavelength in a wavelength band corresponding to red light among external light incident on the display device passes through the first color filter CF1, and a portion of the light passing through the first color filter CF1 is reflected by the opposite electrode 315 or the pixel electrode 311 therebelow and is emitted to the outside again. As a result, because only a portion of external light incident on a place where the first pixel PX1 is located is reflected to the outside, the first color filter CF1 may reduce the external light reflection. The above descriptions may also be applied to the second color filter CF2 and the third color filter CF3.

The color filters CF may cover the black matrix BM. That is, the color filters CF cover an upper surface of the black matrix BM in a direction (+Z-axis direction) away from the substrate 100. The black matrix BM prevents or substantially prevents external light from proceeding to the display element 310 or the like, but a portion of the external light may be reflected by an upper surface of the black matrix BM. Accordingly, an amount of external light reflected may be further reduced by covering the upper surface of the black matrix BM with a material having a reflectance lower than that of the black matrix BM. In an embodiment, the reflectance of the black matrix BM is about 4%, and the color filters CF having a reflectance of about 3% may cover the black matrix BM.

The black matrix BM may include a light-blocking insulating material. Accordingly, the black matrix BM is a light-blocking insulating layer which is colored and opaque, and, for example, may appear black. For example, the black matrix BM may include a PI-based binder, and a pigment in which red, green, and blue colors are mixed with each other. In an embodiment, the black matrix BM may include a binder resin, and a mixture of a lactam black pigment and a blue pigment. In an embodiment, the black matrix BM may include carbon black.

However, this is only one embodiment, and the anti-reflection layer may not necessarily include the color filter CF and the black matrix BM to prevent or substantially prevent unnecessary reflection of light, and at least one of the color filter CF and the black matrix BM may be omitted.

The display substrate DS described with reference to FIGS. 1 to 6B may include at least one of the substrate 100 and the pixel electrode 311 described with reference to FIG. 8. In addition, the deposition material M described with reference to FIGS. 1 to 6B may include the intermediate layer 313 described with reference to FIG. 8.

In an embodiment, because the planar shape of the opening portion 442 includes a circular shape as described with reference to FIGS. 1 to 6B, the planar shape of the intermediate layer 313 may also include a circular shape. In such a structure, unnecessary or undesired reflection of light in the intermediate layer 313 may be reduced.

In the structure described with reference to FIGS. 4A to 6B, as the blind spot RA of the opening portion 442 is reduced, the size of each of the intermediate layers 313 may be increased. In such a structure, as the size of each of the intermediate layers 313 is increased, the size of each of pixel openings POP may be sufficiently secured.

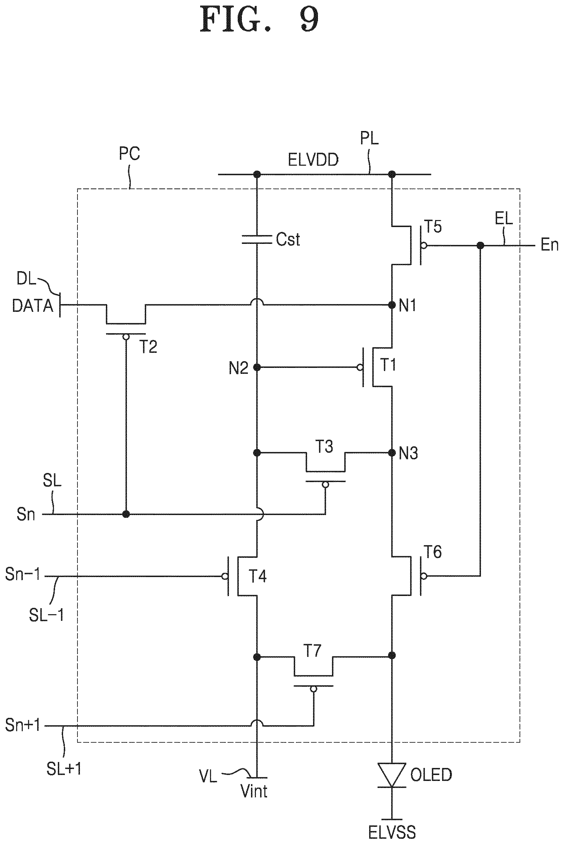

FIG. 9 is an equivalent circuit diagram of a pixel according to an embodiment.

Referring to FIG. 9, a pixel circuit PC may include first to seventh transistors T1 to T7, and, according to a transistor type (p-type or n-type) and/or an operating condition, a first terminal of each of the first to seventh transistors T1 to T7 may be a source terminal or a drain terminal, and a second terminal thereof may be a terminal different from the first terminal. For example, when the first terminal is a source terminal, the second terminal may be a drain terminal.

The pixel circuit PC may be connected to a first scan line SL configured to transmit a first scan signal Sn, a second scan line SL-1 configured to transmit a second scan signal Sn-1, a third scan line SL+1 configured to transmit a third scan signal Sn+1, an emission control line EL configured to transmit an emission control signal En, a data line DL configured to transmit a data signal DATA, a driving voltage line PL configured to transmit a driving voltage ELVDD, and an initialization voltage line VL configured to transmit an initialization voltage Vint.

The first transistor T1 includes a gate terminal connected to a second node N2, a first terminal connected to a first node N1, and a second terminal connected to a third node N3. The first transistor T1 functions as a driving transistor and receives the data signal DATA according to a switching operation of the second transistor T2 to supply a driving current to a light-emitting element. The light-emitting element may be an organic light-emitting diode OLED.

The second transistor T2 (switching transistor) includes a gate terminal connected to the first scan line SL, a first terminal connected to the data line DL, and a second terminal connected to the first node N1 (or the first terminal of the first transistor T1). The second transistor T2 may be turned on according to the first scan signal Sn received through the first scan line SL and may perform a switching operation of providing the data signal DATA provided to the data line DL to the first node N1.

The third transistor T3 (compensation transistor) includes a gate terminal connected to the first scan line SL, a first terminal connected to the second node N2 (or the gate terminal of the first transistor T1), and a second terminal connected to the third node N3 (the second terminal of the first transistor T1). The third transistor T3 may be turned on according to the first scan signal Sn received via the first scan line SL to diode-connect the first transistor T1. The third transistor T3 may have a structure in which two or more transistors are connected in series.

The fourth transistor T4 (first initialization transistor) includes a gate terminal connected to the second scan line SL-1, a first terminal connected to the initialization voltage line VL, and a second terminal connected to the second node N2. The fourth transistor T4 may be turned on according to the second scan signal Sn-1 received through the second scan line SL-1 and configured to transmit the initialization voltage Vint to the gate terminal of the first transistor T1 to initialize a gate voltage of the first transistor T1. The fourth transistor T4 may have a structure in which two or more transistors are connected in series.

The fifth transistor T5 (first emission-control transistor) includes a gate terminal connected to the emission control line EL, a first terminal connected to the driving voltage line PL, and a second terminal connected to the first node N1. The sixth transistor T6 (second emission-control transistor) includes a gate terminal connected to the emission control line EL, a first terminal connected to the third node N3, and a second terminal connected to a pixel electrode of the organic light-emitting diode OLED. The fifth transistor T5 and the sixth transistor T6 are concurrently (e.g., simultaneously) turned on according to the emission control signal En received through the emission control line EL, and, thus, a current flows to the organic light-emitting diode OLED.

The seventh transistor T7 (second initialization transistor) includes a gate terminal connected to the third scan line SL+1, a first terminal connected to the second terminal of the sixth transistor T6 and the pixel electrode of the organic light-emitting diode OLED, and a second terminal connected to the initialization voltage line VL. The seventh transistor T7 may be turned on according to the third scan signal Sn+1 received through the third scan line SL+1 and configured to transmit the initialization voltage Vint to the pixel electrode of the organic light-emitting diode OLED to initialize a voltage of the pixel electrode of the organic light-emitting diode OLED. In an embodiment, the seventh transistor T7 may be omitted.

A capacitor Cst includes a first electrode connected to the second node N2 and a second electrode connected to the driving voltage line PL.

The organic light-emitting diode OLED may include the pixel electrode and an opposite electrode facing the pixel electrode, and the opposite electrode may receive a common voltage ELVSS. The organic light-emitting diode OLED may receive a driving current from the first transistor T1 and emit light in a certain color to display an image. The opposite electrode may be provided in common to a plurality of pixels, that is, integrally.

Embodiments of the present disclosure may increase the efficiency and lifespan of a display device by reducing a blind spot formed in an opening portion of a mask sheet of a mask assembly.

However, effects of the present disclosure are not limited to the effects mentioned above, and other effects not mentioned will be clearly understood by one of ordinary in the art from the above description and the claims.

It is to be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the invention as set forth by the following claims.

## Claims

1. A mask assembly (40) comprising a mask sheet (44) configured to pass a deposition material therethrough,
wherein the mask sheet comprises:
a body portion (441) defining an exterior of the mask sheet;
one or more opening portions (442) in the body portion; and
one or more groove portions (443) in the body portion,
wherein at least one of the one or more groove portions overlaps an inner surface of at least one of the one or more opening portions.

2. The mask assembly of claim 1, wherein the one or more opening portions comprise a first opening portion (442-1), a second opening portion (442-2), a third opening portion (442-3), and a fourth opening portion (442-4), which are arranged adjacent to each other,
the one or more groove portions (443) comprise a first groove portion (443-1), and
the first groove portion is in an area between the first opening portion, the second opening portion, the third opening portion, and the fourth opening portion.

3. The mask assembly of claim 2, wherein an inner surface of each of the first opening portion, the second opening portion, the third opening portion, and the fourth opening portion overlaps the first groove portion.

4. The mask assembly of claim 1, wherein the one or more opening portions comprise a first opening portion and a second opening portion, which are arranged adjacent to each other,
the one or more groove portions comprise a first groove portion, and
the first groove portion is in an area between the first opening portion and the second opening portion.

5. The mask assembly of claim 4, wherein an inner surface of each of the first opening portion and the second opening portion overlaps the first groove portion.

6. The mask assembly of claim 1, wherein the one or more opening portions comprise a first opening portion,
the one or more groove portions comprise a first groove portion and a second groove portion, and
the first groove portion and the second groove portion overlap an inner surface of the first opening portion.

7. The mask assembly of claim 6, wherein the first groove portion and the second groove portion overlap each other.

8. The mask assembly of claim 1, wherein a planar shape of at least one of the one or more opening portions comprises a circular shape.

9. The mask assembly of claim 1, wherein a planar shape of the one or more groove portions comprises a shape corresponding to a planar shape of the one or more opening portions.

10. An apparatus for manufacturing a display device, the apparatus comprising:
a chamber;
a deposition source arranged inside the chamber and configured to supply the deposition material; and
a mask assembly according to any one of the preceding claims arranged inside the chamber.

11. The apparatus of claim 10, wherein the inner surface of the at least one opening portion comprises an inclined surface inclined toward the deposition source.

12. A method of manufacturing a display device, the method comprising:
arranging a display substrate and a mask assembly according to any one of the claims 1 to 9 inside a chamber; and
depositing a deposition material supplied from a deposition source on the display substrate through the mask sheet of the mask assembly.,
wherein the mask sheet comprises:
a body portion defining an exterior of the mask sheet;
one or more opening portions in the body portion; and
one or more groove portions in the body portion,
wherein at least one of the one or more groove portions overlaps an inner surface of at least one of the one or more opening portions.

13. The method of claim 12, wherein an inner surface of the one or more opening portions comprises an inclined surface inclined toward the deposition source.
